(19) **Europäisches Patentamt / European Patent Office / Office européen des brevets**

(11) **EP 1 251 359 B1**

(12) **EUROPÄISCHE PATENTSCHRIFT**

(45) Veröffentlichungstag und Bekanntmachung des Hinweises auf die Patenterteilung:
**18.02.2009 Patentblatt 2009/08**

(51) Int Cl.:
**G01R 31/36** (2006.01)

(21) Anmeldenummer: **02003305.6**

(22) Anmeldetag: **13.02.2002**

(54) **Verfahren und Anordnung zur Bestimmung des Zustands einer Batterie**

Method and device for the determination of the status of a battery

Procédé et dispositif pour la détermination du statut d'une batterie

(84) Benannte Vertragsstaaten:
**DE ES FR GB IT**

(30) Priorität: **19.04.2001 DE 10118916**

(43) Veröffentlichungstag der Anmeldung:
**23.10.2002 Patentblatt 2002/43**

(73) Patentinhaber: **ROBERT BOSCH GMBH**
**70442 Stuttgart (DE)**

(72) Erfinder:
• **Hoetzer, Dieter, Dr.**
**70701 Schwieberdingen (DE)**
• **Bischoff, Claus**
**70469 Stuttgart (DE)**

(56) Entgegenhaltungen:
**DE-A- 19 831 723**

• **PATENT ABSTRACTS OF JAPAN vol. 018, no. 018 (P-1673), 12. Januar 1994 (1994-01-12) & JP 05 256924 A (HITACHI LTD), 8. Oktober 1993 (1993-10-08)**
• **PATENT ABSTRACTS OF JAPAN vol. 1996, no. 07, 31. Juli 1996 (1996-07-31) & JP 08 079903 A (SUZUKI MOTOR CORP), 22. März 1996 (1996-03-22)**
• **PATENT ABSTRACTS OF JAPAN vol. 1996, no. 02, 29. Februar 1996 (1996-02-29) & JP 07 274306 A (HINO MOTORS LTD), 20. Oktober 1995 (1995-10-20)**

## Beschreibung

Technisches Gebiet

Die vorliegende Erfindung betrifft ein Verfahren und eine Anordnung zur Bestimmung des Zustands einer Batterie nach dem Oberbegriff der Patentansprüche 1 bzw. 8.

Stand der Technik

In heutigen und zukünftigen Kraftfahrzeugen werden vermehrt elektrische Verbraucher integriert, deren Funktionen teilweise sicherheitskritisch für den Betrieb der Fahrzeuge sind. Als Beispiele seien genannt elektrische Lenkungssysteme und elektrohydraulische Bremssysteme (EHB). Der sichere Betrieb derartiger Komponenten setzt eine betriebsbereite und "gesunde" Batterie im Bordnetz voraus. Automobilhersteller fordern deshalb im zunehmendem Maße eine zuverlässige Batteriezustandsüberwachung für in Kraftfahrzeugen einzusetzende Batterien.

Es ist möglich, den bei einem Startvorgang eines Verbrennungsmotors am Innenwiderstand der Starterbatterie auftretenden Spannungsabfall zu messen. Hierbei wird ausgenutzt, dass während des Startvorgangs eines Verbrennungsmotors ein derart hoher Strom fließt, dass es zu einem Spannungsabfall im Innenwiderstand der Batterie kommt. Eine sich hierbei ergebende minimale Spannung kann dann zur Bestimmung des Zustands bzw. Gesundheitszustands der Batterie verwendet werden. Derartige Verfahren setzen jedoch voraus, dass die zu einem Motorstart benötigten Batterieströme proportional zur Motortemperatur sind, da beispielsweise die Reibleistung im Verbrennungsmotor im wesentlichen eine Funktion der Motortemperatur ist. Ein so gemessener Spannungsabfall wird dann mit vorab ermittelten Referenzwerten, die als Funktion der Motortemperatur und der Batterieleerlaufspannung hinterlegt sein müssen, verglichen, wobei aus einem derartigen Vergleich der Zustand der Batterie abgeleitet werden kann.

Nachteilig an diesen Verfahren ist der hohe Applikationsaufwand, d.h. für jeden Verbrennungsmotor muß eine neue Applikation der Batteriezustands-Referenzwerte durchgeführt werden. Darüber hinaus ist beim Startvorgang die benötigte Batterieleistung auch bei bekannter bzw. konstanter Motortemperatur sehr stark von Umweltbedingungen und thermodynamischen Rahmenbedingungen abhängig, und damit sehr schlecht reproduzierbar.

Aus der DE 198 31 723 A ist ein Verfahren zur Ladezustandserkennung bei einer Fahrzeugbatterie bekannt, bei dem während des Betriebs des Starters der Spannungsabfall der Batteriespannung erfasst wird. Aus dem Spannungsabfall wird anschließend ein mit diesem zusammenhängender Ladezustandswert ermittelt.

Mit der Erfindung wird angestrebt, eine Bestimmung des Zustandes einer Fahrzeugbatterie vor dem Start eines Motors, insbesondere eines Verbrennungsmotors oder eines Hybrid-Motors, mit hoher Genauigkeit und möglichst unabhängig von Umwelteinflüssen durchzuführen.

Diese Aufgabe wird gelöst durch ein Verfahren mit den Merkmalen des Patentanspruchs 1 sowie eine entsprechende Anordnung mit den Merkmalen des Patentanspruchs 8.

Erfindungsgemäß ist vorgesehen, einen an die Batterie anschließbaren elektrischen Verbraucher mit einem definierten Stromprofil zu beaufschlagen. Unter definiertem Stromprofil wird insbesondere ein über einen definierbaren Zeitraum fließender Strom definierbarer Stärke verstanden. Bei herkömmlichen Verfahren, bei denen zum Motorstart benötigte Batterieströme zur Feststellung eines Spannungsabfalls herangezogen wurden, ist keine derartige Einstellung eines definierten Stromprofils möglich. Beispielsweise ist es bei herkömmlichen Startermotoren nicht möglich, eine gewünschte Bestromungsdauer einzustellen, da es unmittelbar nach dem Anspringen des dem Startermotor zugeordneten Verbrennungsmotors zu einer Entkopplung von Startermotor und Kurbelwelle des Verbrennungsmotors und einer Beendigung der Bestromung des Startermotors kommt. Ferner ist der von einem Startermotor entnommene Strom über die Startphase nicht konstant, so dass bei herkömmlichen Verfahren eine rechnerisch relativ aufwendige Mittelwertbildung erfolgen musste.

Erfindungsgemäß ist es nun möglich, einen elektrischen Verbraucher über einen definierten Zeitraum mit einem definierten Strom zu beaufschlagen.

Vorteilhafte Ausgestaltungen des erfindungsgemäßen Verfahrens bzw. der erfindungsgemäßen Anordnung sind Gegenstand der Unteransprüche.

Als elektrischer Verbraucher ist bevorzugt eine Elektromaschine (E-Maschine) mit hohem Leistungspotential, beispielsweise eine an der Kurbelwelle angekoppelte E-Maschine mit Starter- und Generatorfunktionen oder einen Elektroantriebsmotor, zu verwenden. Über eine geeignete Ansteuerung derartiger E-Maschinen kann eine Einstellung eines definierten Stromprofils auch über sehr kurze Zeiträume erreicht werden, da diese Maschinen einen hohen Leistungsbedarf aufweisen. Der Zusatzaufwand für die Realisierung einer derartigen Funktion ist sehr gering, da in Hochleistungs-Elektromaschinen eine Bereitstellung und Messung hoher Ströme unabhängig von einer Batteriezustandsbestimmung häufig realisiert ist.

Zweckmäßigerweise wird die Elektromaschine in einem von einem Antriebsstrang bzw. Getriebemechanismus des Fahrzeugs abgekoppelten Zustand durch die Strombeaufschlagung motorisch betrieben. Diese Vorgehensweise eignet sich insbesondere zur Darstellung von kurzzeitigem Stromprofilen. Bei dieser Betriebsart beschleunigt die Elektromaschine bei Beaufschlagung mittels des Batteriestromes. Zweckmäßigerweise ist die Dauer des Stromprofils durch die maximale Drehzahl der Elektromaschine festgelegt, d. h. die Dauer der Strombeaufschlagung sollte so gewählt werden, dass die maximale Drehzahl der Elektromaschine nicht erreicht wird.

Vorteilhafterweise wird anschließend an diesen motorischen Betrieb die Elektromaschine im Generatorbetrieb betrieben. Mit dieser Maßnahme ist es möglich, einen Großteil des der Batterie entnommenen Stromes an diese zurückzuliefern.

Gemäß einer weiteren bevorzugten Ausführungsform des erfindungsgemäßen Verfahrens wird die Elektromaschine derart geregelt, dass die durch die Strombeaufschlagung zur Verfügung gestellte Energie im wesentlichen in Wärme umgesetzt wird. Diese Betriebsart erweist sich insbesondere im Falle von kühleren Umgebungstemperaturen als vorteilhaft, da die so entstehende Wärme zur Erwärmung des Motors bzw. von Motorkomponenten in einen Wärmekreislauf des Kraftfahrzeugs eingespeist werden kann.

Zweckmäßigerweise wird zur Realisierung dieser Betriebsart die Elektromaschine mittels Verblocken des Getriebemechanismus und Schließen einer Radbremse oder durch eigene (d. h. der jeweiligen Elektromaschine zugeordnete) Bandbremsen festgehalten und/oder stromgeregelt betrieben.

Gemäß einer weiteren bevorzugten Ausführungsform des erfindungsgemäßen Verfahrens wird im Falle des Vorhandenseins von zwei Elektromaschinen vorgesehen, daß diese gegeneinander arbeiten, d. h. eine erste im Generatorbetrieb und eine zweite im elektromotorischen Betrieb, und sich hierbei insbesondere in ihrer jeweiligen Wirkung aufheben. Auch mit dieser Maßnahme ist ein in gewünschter Weise geregelter Betrieb der Elektromaschine realisierbar.

Weitere Vorteile der Erfindung ergeben sich aus der nachfolgenden Beschreibung bevorzugter Ausführungsbeispiele und der beigefügten Zeichnung.

Zeichnung

Bevorzugte Ausführungsformen der Erfindung werden nun anhand der beigefügten Zeichnungen näher beschrieben. In dieser zeigt:

Figur 1 ein Diagramm zur Erläuterung des verwendeten Begriffs "Batteriegesundheitszustand",

Figur 2 ein schematisches Blockschaltbild einer bevorzugten Ausführungsform der erfindungsgemäßen Anordnung, und

Figur 3 ein Prinzipbild eines Dual-Elektrogetriebes, bei welchem die erfindungsgemäße Anordnung bzw. das erfindungsgemäße Verfahren vorteilhaft einsetzbar ist.

Beschreibung bevorzugter Ausführungsformen

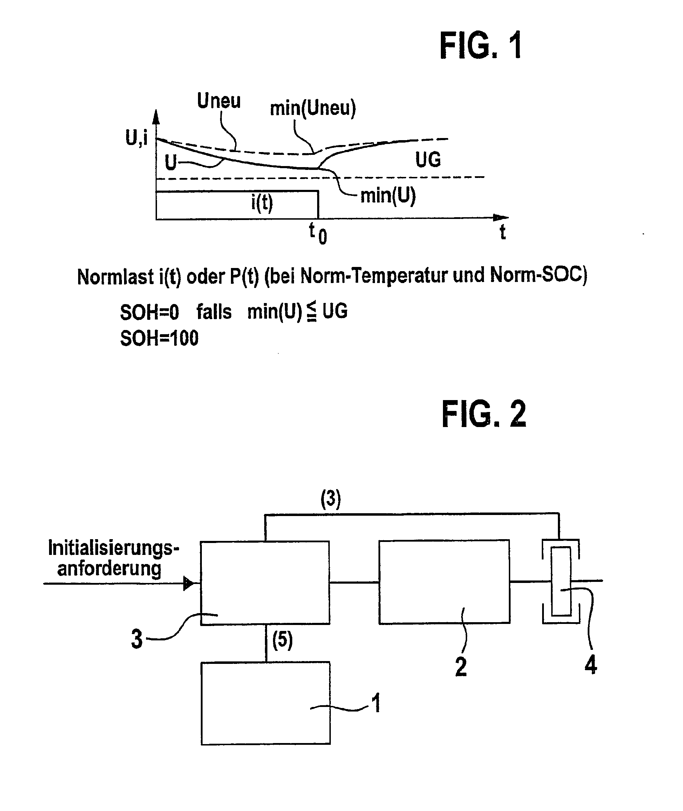

In Fig. 1 sind Batteriespannung U bzw. Batteriestrom i gegen die Zeit aufgetragen dargestellt. Man erkennt, dass über eine bestimmte Zeit $t_0$ ein konstanter Batteriestrom vorliegt. Im Falle einer neuen Batterie sinkt in dieser Zeit die Batteriespannung Uneu auf einen Wert min(Uneu). Im Falle einer bereits älteren Batterie sinkt die Batteriespannung U auf einen Wert min(U).

Bei dem Strom i(t) handelt es sich um eine Normlast bei Norm-Temperatur und Norm-Ladezustand, wobei gilt, dass die minimale Batteriespannung min(U) größer als ein Grenzwert UG ist. Für den Fall, dass die Batteriespannung nach Ablauf der Zeit $t_0$ größer als der Grenzwert UG ist, wird der Gesundheitszustand SOH (engl.: State of Health) als > 0 definiert. Für den Fall, dass min(U)≤ UG ist, gilt SOH = 0. Ein Gesundheitszustand SOH = 100 ergibt sich für min (U) =min (Uneu), d. h. bei neuer Batterie in Normumgebung. Ein konkreter Gesundheitszustand SOH ergibt sich als

$$ SOH = \frac{\max[(\min(U) - UG),0]}{\min(Uneu) - UG} $$

Die Vorgabe eines gleichmäßigen Stromprofils, wie in Fig. 1 dargestellt ist, gestaltete sich herkömmlicherweise als sehr aufwendig. Hier setzt die vorliegende Erfindung an.

In Fig. 2 sind als wesentliche Komponenten der erfindungsgemäßen Anordnung eine Batterie 1, eine Elektromaschine 2, ein Steuergerät, beispielsweise ein Pulswechselrichter 3 und eine Bremse 4 dargestellt.

Im Rahmen eines vor einem eigentlichen Motorstart ablaufenden Initialisierungsprozesses wird in dem Steuergerät bei einer Initialisierungsanforderung eine Routine gestartet, die die Elektromaschine 2 mit einem definierten Strom aus der Batterie 1 beaufschlagt. Im Steuergerät kann über die Zuleitung 5 der resultierende Spannungsabfall der Batterie gemessen, und anhand hinterlegter Referenzwerte ein entsprechender Gesundheitszustand SOH der Batterie 1 bestimmt werden.

Die in der Elektromaschine 2 aufgrund der Strombeaufschlagung zur Verfügung stehende elektrische Leistung kann beispielsweise in motorische Leistung umgesetzt werden. Diese Vorgehensweise eignet sich insbesondere zur Erzeugung von kurzzeitigen Stromprofilen, wobei hier die Elektromaschine 2 zweckmäßigerweise abgekoppelt von einem (nicht dargestellten) Antriebsstrang des Kraftfahrzeugs, d.h. im Leerlauf, betrieben wird. Dies führt zu einer Beschleunigung der Elektromaschine 2, wobei darauf zu achten ist, dass eine maximale Drehzahl der Elektromaschine nicht überschritten wird. Dies kann beispielsweise dadurch sichergestellt werden, dass die Dauer des Stromprofils entsprechend begrenzt wird.

Es ist ebenfalls denkbar, die Elektromaschine 2 stromgeregelt derart anzusteuern, dass die gesamte elektrische Leistung in Wärme, und nicht in mechanische Rotationsenergie umgesetzt wird. Zu diesem Zwecke kann die Elektromaschine 2 mittels der Bremse 4 festgehalten werden.

Durch diese Maßnahme ist es möglich, die Elektromaschine auch mit sehr hohen, definierten Strömen aus der Batterie über beliebige Zeiträume zu beaufschlagen.

Die Umwandlung der Batterieenergie in motorische Leistung weist insoweit Vorteile auf, als die Elektromaschine 2 nach Beendigung der Strombeaufschlagung in einem Generatorbetrieb arbeiten kann, wodurch die der Batterie entnommene elektrische Energie zum Großteil an diese zurückgegeben werden kann, so dass die Batteriebelastung insgesamt minimiert werden kann.

Die bei der Umsetzung der Batterieenergie in Verlustleistung entstehende Wärme kann in einen Wärmekreislauf des Kraftfahrzeugs eingespeist werden, wodurch sich Vorteile beispielsweise beim Winterbetrieb ergeben.

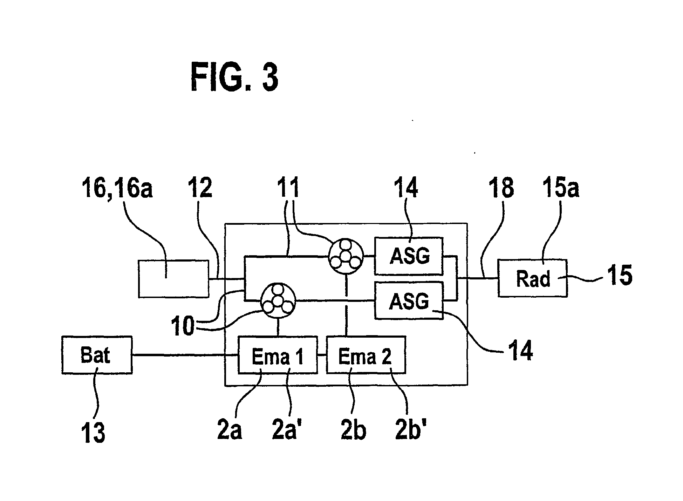

Anhand der Figur 3 wird nun eine weitere bevorzugte Ausführungsform der erfindungsgemäßen Anordnung dargestellt.

Man erkennt ein leistungsverzweigendes Getriebe für Hybridfahrzeuge, welches zwei Elektromaschinen 2a, 2b aufweist, welche beide über entsprechende Getriebemechanismen 10, 11 mit der Kurbelwelle 12 des Verbrennungsmotors 16 in Wirkverbindung stehen.

Das sich aufgrund des Zusammenwirkens von Verbrennungsmotor und Elektromotoren 2a, 2b ergebende Gesamtdrehmoment wird über die Gangstufen eines automatisierten Schaltgetriebes 14 auf eine Abtriebswelle 18 übertragen.

Die Hochleistungsbatterie bzw. Traktionsbatterie 13 kann zur Bestimmung des Gesundheitszustands wie oben durch die Elektromaschinen 2a, 2b mit einem definierten Stromprofil belastet werden.

Mit der dargestellten Anordnung der Elektromaschinen 2a , 2b kann die Erzeugung eines definierten Stromprofils und die Messung eines Referenz-Spannungsabfalls mit den nachfolgend beschriebenen alternativen Konzepten umgesetzt werden:

Zunächst ist es möglich, durch Ansteuerung der Motorbremse 16a des Motors 16 und Verblocken der Getriebemechanismen 10, 11 die Elektromaschine 2a bzw. 2b festzuhalten. Hierbei ist darauf zu achten, dass auf den jeweiligen Wellen der automatisierten Schaltgetriebe jeweils Gänge eingelegt sind.

Es sei angemerkt, daß es auch zielführend sein kann, die Elektromaschinen 2a, 2b mit eigenen Bandbremsen 2a', 2b' zu versehen. Es ist dann ohne ein Verblocken der Getriebemechanismen möglich, die Elektromaschinen (gegebenenfalls auch einzeln) festzuhalten.

Es sei ferner angemerkt, daß das Verblocken der Getriebemechanismen durch Schließen einer Radbremse 15a eines Rades 15 unterstützt bzw. bewerkstelligt werden kann.

Bei dieser Betriebsart kann, wie bereits oben erläutert, die Batterieenergie in Wärmeenergie umgesetzt werden.

Es ist ebenfalls denkbar, ein freies Drehen der Elektromaschinen 2a bzw. 2b zuzulassen. Diese Betriebsart ist möglich, wenn kein Gang eingelegt ist und die Motorbremse 16 des Motors 16 dafür sorgt, dass der Verbrennungsmotor nicht mitdreht.

Durch das Vorhandensein von zwei Elektromaschinen kann auch eine für die gewünschte Batteriezustandsbestimmung genügend hohe und definierte Laststromvorgabe durch "Verheizen" elektrischer Energie in den Ständerwicklungen der Elektromaschinen erfolgen, indem in geeigneter Weise dafür gesorgt wird, dass keine mechanische Energie abgegeben wird. Bei einer Klauenpolmaschine (fremderregte Synchronmaschine) kann dies dadurch realisiert werden, dass der Erregerstrom für den Rotor gleich Null gesetzt wird.

## Patentansprüche

1. Verfahren zur Bestimmung des Gesundheitszustandes (SOH) einer Batterie (1) eines Fahrzeugs mit folgenden Schritten

   - Beaufschlagung wenigstens eines mit der Batterie verbundenen elektrischen Verbraucher (2; 2a, 2b) mit einem zeitlich und betragsmäßig definierten Stromprofil mittels eines Batteriestroms, wobei die Einstellung des Stromprofils durch eine geeignete Ansteuerung des elektrischen Verbrauchers erreicht wird,
   - Bestimmung des hierbei auftretenden Spannungsabfalls in der Batterie durch Messung des Spannungsabfalls an einer Zuleitung, insbesondere des maximalen Spannungsabfalls in der Batterie (1), und
   - Bestimmung des Gesundheitszustands (SOH) der Batterie (1) auf der Grundlage des auftretenden Spannungsabfalls und anhand hinterlegter Referenzwerte.

2. Verfahren nach Anspruch 1, **dadurch gekennzeichnet, dass** als elektrischer Verbraucher wenigstens eine Elektromaschine (2, 2a, 2b) eines Hybridfahrzeugs verwendet wird.

3. Verfahren nach Anspruch 2, **dadurch gekennzeichnet, dass** die Elektromaschine (2; 2a, 2b) in einem von einem Antriebsstrang bzw. Getriebemechanismus des Fahrzeugs abgekoppelten Zustand mittels des von der Batterie gelieferten Batteriestromes motorisch betrieben wird.

4. Verfahren nach Anspruch 3, **dadurch gekennzeichnet, dass** die Elektromaschine (2; 2a, 2b) anschließend an ihre Strombeaufschlagung mittels des Batteriestroms im Generatorbetrieb betrieben wird.

5. Verfahren nach einem der vorstehenden Ansprüche, **dadurch gekennzeichnet, dass** die Elektromaschine (2; 2a, 2b) derart geregelt wird, dass die durch die Strombeaufschlagung zur Verfügung gestellte Energie im Wesentlichen in Wärme bzw. Verlustleistung umgesetzt wird.

6. Verfahren nach Anspruch 5, **dadurch gekennzeichnet, dass** die Elektromaschine (2; 2a, 2b) mittels Verblocken des Getriebemechanismus (10, 11) und Schließen einer Radbremse (15a) oder durch eigene Bandbremsen festgehalten order strom geregelt betrieben wird.

7. Verfahren nach Anspruch 5, **dadurch gekennzeichnet, dass** im Falle des Vorhandenseins von zwei Elektromaschinen (2a, 2b) diese gegeneinander arbeiten und sich hierbei insbesondere in ihrer jeweiligen Wirkung aufheben.

8. Verfahren nach einem der vorhergehenden Ansprüche, **dadurch gekennzeichnet, dass** es im Rahmen eines vor dem eigentlichen Motorstart ablaufenden Initialisierungsprozess abläuft.

9. Anordnung zur Bestimmung des Gesundheitszustandes (SOH) einer Batterie (1) eines Fahrzeugs mit einem Steuergerät (3) zur Beaufschlagung wenigstens eines mit der Batterie verbundenen elektrischen Verbrauchers (2; 2a, 2b) mit einem zeitlich und betragsmäßig definierten Stromprofil mittels eines Batteriestroms, wobei die Einstellung des Stromprofils durch eine geeignete Ansteuerung des elektrischen Verbrauchers erreichbar ist und wobei das Steuergerät (3) Mittel zur Bestimmung des bei der Strombeaufschlagung des Verbrauchers (2; 2a, 2b) in der Batterie (1) auftretenden Spannungsabfalls durch Messung des Spannungsabfalls an einer Zuleitung (5), insbesondere des maximalen Spannungsabfalls umfasst, und das Steuergerät (3) Mittel zur Bestimmung des Zustandes der Batterie auf der Grundlage des auftretenden Spannungsabfalls und anhand hinterlegter Referenzwerte umfasst.

**Claims**

1. Method for determining the state of health (SOH) of a battery (1) of a vehicle having the following steps:

   - a battery current is used to apply a current profile which is defined in terms of timing and absolute value to at least one electric load (2; 2a, 2b) which is connected to the battery, wherein the current profile is set by suitably actuating the electric load,
   - the voltage drop which occurs at the battery in this context is determined by measuring the voltage drop at a feed line, in particular the maximum voltage drop at the battery (1), and
   - the state of health (SOH) of the battery (1) is determined on the basis of the voltage drop which occurs and on the basis of stored reference values.

2. Method according to Claim 1, **characterized in that** at least one electric machine (2, 2a, 2b) of a hybrid vehicle is used as the electric load.

3. Method according to Claim 2, **characterized in that** in a state in which the electric machine (2; 2a, 2b) is decoupled from a drive train or transmission mechanism of the vehicle, said electric machine (2; 2a, 2b) is operated by a motor by means of the battery current which is supplied by the battery.

4. Method according to Claim 3, **characterized in that** subsequent to the application of current to the electric machine (2; 2a, 2b), said electric machine (2; 2a, 2b) is operated in the generator mode by means of the battery current.

5. Method according to one of the preceding claims, **characterized in that** the electric machine (2; 2a, 2b) is controlled in such a way that the energy which is made available by the application of current is converted essentially into heat or dissipated power.

6. Method according to Claim 5, **characterized in that** the electric machine (2; 2a, 2b) is stopped by blocking the transmission mechanism (10, 11) and closing a wheel brake (15a) or by strap brakes or is operated through current control.

7. Method according to Claim 5, **characterized in that** if two electric machines (2a, 2b) are present, they operate in opposition to one another and in particular cancel one another out in their respective effect.

8. Method according to one of the preceding claims, **characterized in that** said method occurs within the scope of an initialization process running before the engine actually starts.

9. Arrangement for determining the state of health (SOH) of a battery (1) of a vehicle having a control device (3) for using a battery current to apply a current profile which is defined in terms of timing and absolute value to at least one electric load (2; 2a, 2b) which is connected to the battery, wherein the current profile can be set by suitably actuating the electric load and wherein the control device (3) comprises means for determining the voltage drop occurring in the battery (1) when the current is applied to the load (2; 2a, 2b), by measuring the voltage drop at a feed line (5), in particular the maximum voltage drop, and the control device (3) comprises means for determining the state of the battery on the basis of the voltage drop which occurs and on the basis of stored reference values.

## Revendications

1. Procédé de détermination de l'état de santé (SOH) de la batterie (1) d'un véhicule, lequel procédé comprend les étapes suivantes :

    - au moyen d'un courant de batterie, application d'un profil de courant dont l'évolution dans le temps et le niveau sont définis sur au moins un consommateur électrique (2; 2a, 2b) raccordé à la batterie, l'établissement du profil de courant étant obtenu par une commande appropriée du consommateur électrique,
    - par mesure de la chute de tension sur un conducteur d'alimentation, détermination de la chute de tension et en particulier de la chute maximale de tension de la batterie (1) qui survient à cette occasion dans la batterie et
    - détermination de l'état de santé (SOH) de la batterie (1) sur base de la chute de tension qui est survenue et à l'aide de valeurs de référence conservées.

2. Procédé selon la revendication 1, **caractérisé en ce que** comme consommateur électrique, on utilise au moins la machine électrique (2; 2a, 2b) d'un véhicule hybride.

3. Procédé selon la revendication 2, **caractérisé en ce que** la machine électrique (2; 2a, 2b) est utilisée comme moteur au moyen du courant de batterie délivré par la batterie pendant que le train d'entraînement ou le mécanisme de transmission du véhicule sont débranchés.

4. Procédé selon la revendication 3, **caractérisé en ce que** la machine électrique (2; 2a, 2b) est ensuite utilisée comme génératrice en étant alimentée en courant par la batterie.

5. Procédé selon l'une des revendications précédentes, **caractérisé en ce que** la machine électrique (2; 2a, 2b) est réglée de à convertir l'énergie apportée par l'alimentation en courant essentiellement en chaleur ou en puissance de perte.

6. Procédé selon la revendication 5, **caractérisé en ce que** la machine électrique (2; 2a, 2b) est bloquée par ses propres freins ou utilisée sous courant régulé par blocage du mécanisme de transmission (10, 11) et fermeture d'un frein de roue (15a).

7. Procédé selon la revendication 5, **caractérisé en ce qu'**en cas de présence de deux machines électriques (2a, 2b), ces dernières travaillent en opposition l'une à l'autre de telle sorte qu'en particulier leurs effets se suppriment mutuellement.

8. Procédé selon l'une des revendications précédentes, **caractérisé en ce qu'**il se déroule dans le cadre d'une opération d'initialisation qui se déroule avant le démarrage proprement dit du moteur.

9. Système de détermination de l'état de santé (SOH) de la batterie (1) d'un véhicule, qui présente un appareil de commande (3) qui, au moyen du courant de batterie, alimente au moins un consommateur électrique (2; 2a, 2b) relié à la batterie selon un profil de courant dont l'évolution dans le temps et le niveau sont définis, le profil de courant pouvant être établi par une commande appropriée du consommateur électrique, l'appareil de commande (3) comprenant des moyens de détermination de la chute de tension qui survient dans la batterie (1) lorsque le consommateur (2; 2a, 2b) est alimenté en courant, par mesure de la chute de tension et en particulier de la chute de tension maximale sur un conducteur d'alimentation (5), l'appareil de commande (3) comprenant des moyens de détermination de l'état de la batterie sur base de la chute de tension qui survient et à l'aide de valeurs de référence conservées.

# FIG. 1

Normlast i(t) oder P(t) (bei Norm-Temperatur und Norm-SOC)

SOH=0   falls   $\min(U) \leqq UG$
SOH=100

# FIG. 2

# FIG. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19831723 A